(19) **Europäisches Patentamt**
**European Patent Office**
**Office européen des brevets**

(11) **EP 4 199 070 A1**

(12) **EUROPEAN PATENT APPLICATION**

(43) Date of publication:
**21.06.2023 Bulletin 2023/25**

(21) Application number: **22213185.6**

(22) Date of filing: **13.12.2022**

(51) International Patent Classification (IPC):
**H01L 23/15** (2006.01)     **H01L 23/498** (2006.01)
**H01L 23/64** (2006.01)

(52) Cooperative Patent Classification (CPC):
**H01L 23/15; H01L 23/49827; H01L 23/642;**
**H01L 28/40;** H01L 23/49816

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **16.12.2021 US 202117553214**

(71) Applicant: **INTEL Corporation**
**Santa Clara, CA 95054 (US)**

(72) Inventors:
• **PANDI, Sivaseetharaman**
**Chandler, 85225 (US)**
• **COLLINS, Andrew**
**Chandler, 85249 (US)**
• **SAIN, Arghya**
**Chandler, 85224 (US)**
• **KAMGAING, Telesphor**
**Chandler, 85249 (US)**

(74) Representative: **2SPL Patentanwälte PartG mbB**
**Landaubogen 3**
**81373 München (DE)**

(54) **COUPLED FINS WITH BLIND TRENCH STRUCTURES**

(57)     Embodiments disclosed herein include an electronic package. In an embodiment, the electronic package comprises a core, where the core comprises glass, and a first via through the core. In an embodiment, a first fin extends out laterally from the first via. In an embodiment, the electronic package further comprises a second via through the core, and a second fin extending out laterally from the second via. In an embodiment, a face of the first fin overlaps a face of the second fin.

**FIG. 2**

**Description**

**TECHNICAL FIELD**

Embodiments of the present disclosure relate to electronic packages, and more particularly to electronic packages with vias through a core that are capacitively coupled by fins that extend out from the vias.

**BACKGROUND**

Single ended interfaces (e.g., graphics DDR interfaces) are approaching data rates up to 20Gbps with current modulation schemes (e.g., non-return-to-zero (NRZ) modulation schemes). This data rate is estimated to double in the near future with the adoption of new schemes (e.g., pulse amplitude modulation (PAM) 4 schemes). Single ended interfaces are notoriously known for high crosstalk, especially from the 3D components of the channel. This transformation to a PAM 4 scheme further sensitizes the channel performance to crosstalk. The far end crosstalk (FEXT) is more significant in determining the channel performances of these single ended high-speed signals as the coupled noise at the far end is comparable to the signal strength at the receiver.

**BRIEF DESCRIPTION OF THE DRAWINGS**

Figure 1 is a graph of the far end crosstalk at different frequencies, in accordance with an embodiment.
Figure 2 is a perspective view illustration of a package substrate with structures to reduce far end crosstalk, in accordance with an embodiment.
Figure 3A is a plan view illustration of a portion of an electronic package with vias that have overlapping fins, in accordance with an embodiment.
Figure 3B is a cross-sectional illustration of the electronic package in Figure 3A along line B-B', in accordance with an embodiment.
Figure 3C is a cross-sectional illustration of the electronic package in Figure 3A along line C-C', in accordance with an embodiment.
Figure 4 is a cross-sectional illustration of an electronic package with a via that includes a fin that has a height that is substantially equal to a height of the via, in accordance with an embodiment.
Figure 5A is a plan view illustration of an electronic package with vias with fins that have an increased spacing between the fins, in accordance with an embodiment.
Figure 5B is a plan view illustration of an electronic package with vias with a larger pitch and fins that have an increased length, in accordance with an embodiment.
Figure 5C is a plan view illustration of an electronic package with vias offset from each other in order to increase the distance between the fins, in accordance with an embodiment.
Figure 5D is a plan view illustration of an electronic package with vias that have rotation relative to each other in order to change the amount of overlap between the fins, in accordance with an embodiment.
Figure 6A is a cross-sectional illustration of a laser exposure process to make morphological changes to a glass substrate, in accordance with an embodiment.
Figure 6B is a cross-sectional illustration of the glass substrate after via openings are formed into the glass substrate, in accordance with an embodiment.
Figure 6C is a cross-sectional illustration of the glass substrate after vias and fins are disposed into the via openings, in accordance with an embodiment.
Figure 6D is a cross-sectional illustration of the glass substrate after pads are provided above and below the vias, in accordance with an embodiment.
Figure 7A is a cross-sectional illustration of a via with a first fin at a top of the via and a second fin at a bottom of the via, in accordance with an embodiment.
Figure 7B is a perspective view illustration of a plurality of vias with overlapping fins, in accordance with an embodiment.
Figure 8A is a plan view illustration of a package substrate with a plurality of vias and fins, in accordance with an embodiment.
Figure 8B is a cross-sectional illustration of the package substrate in Figure 8A along line B-B', in accordance with an embodiment.
Figure 9 is a plan view illustration of a plurality of vias that include multiple fins, in accordance with an embodiment.
Figure 10 is a cross-sectional illustration of an electronic system that comprises a package substrate with vias that include overlapping fins, in accordance with an embodiment.

Figure 11 is a schematic of a computing device built in accordance with an embodiment.

## EMBODIMENTS OF THE PRESENT DISCLOSURE

Described herein are electronic packages with vias through a core that are capacitively coupled by fins that extend out from the vias, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

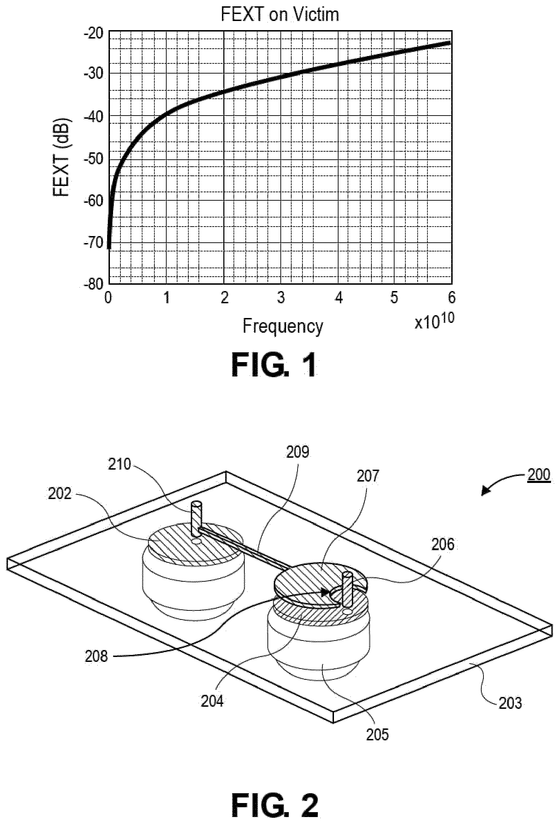

As noted above, increases in frequency along a single ended interface results in an increase in the far end crosstalk (FEXT). This behavior is shown in Figure 1. As shown, the FEXT exhibits a steady increase when the frequency of the signals increase. The necessity to reduce the crosstalk is imperative for the signal integrity of these high-speed signals. Equation 1 shows the voltage coupled to a victim line due to crosstalk at the far end. In Equation 1, FEXT is the far end crosstalk, $V_{in}$ is the input voltage, $T_r$ is the rise time, l is the length of the victim net, L is the self-inductance of the signal line, C is the self-capacitance of the signal line, $L_m$ is the mutual inductance between the victim and aggressor signals, and $C_m$ is the mutual capacitance between the victim and aggressor signals. When the FEXT is inductive, the mutual capacitance is increased to minimize the FEXT.

$$FEXT = \frac{-V_{in}l\sqrt{LC}}{2T_r}\left[\frac{L_m}{L} - \frac{C_m}{C}\right] \qquad \text{Equation 1}$$

Accordingly attempts to increase the mutual capacitance between two signaling lines have been proposed. One proposal is to use coupled vias. Coupled vias are geometric structures implemented to increase the mutual capacitance between any two bits that are routed adjacent to each other in the 3D vertical sections of the package and the board. These structures are implemented when the crosstalk is dominated by inductive coupling. An example of such a structure 200 is shown in Figure 2. In Figure 2, the additional capacitance is provided above the BGA balls 205. In this implementation the first via 210 and the second via 206 extend up from pads 202 and 204, respectively. A dielectric layer 203 is provided over the pads 202 and 204. The mutual capacitance is generated by connecting a second pad 207 to the first via 210 by a trace 209. The second pad 207 is provided over the pad 204 with a cutout 208 to let the via 206 pass through.

An architecture, such as the one shown in Figure 2 has a few limitations. For example, the coupled via architecture of Figure 2 requires an extra routing layer. This increases the package layer count. The length of the trace 209 connecting the coupled via pad 207 to the signal via 210 also determines the return loss of the signal. The length of the trace 209 is determined by the BGA pitch. Longer traces lengths result in higher return losses. Additionally, the ability to modulate the capacitance in a design is limited. The only degree of freedom to vary the mutual capacitance is by varying the radius of the coupled via pad 207.

Accordingly, embodiments disclosed herein include vias that have protruding fins. The fins on the vias can overlap each other in order to provide a desired level of mutual capacitance. There are significantly more degrees of freedom to vary the capacitance, such as changing the height of the fins, changing distances between fins, and changing the length of the fins. Additionally, the fins are provided in the same layer as the vias. Particularly, the vias and the fins may be formed in a core of the package substrate. Accordingly additional layers are not needed to provide the mutual capacitance increase.

It is to be appreciated that such protruding fin architectures are made possible through a laser assisted etching process of the core. In an embodiment, a laser is exposed over one or both surfaces of the glass core. The vias may be formed by via openings that pass entirely through the glass core, while the fins are formed with blind structures. That is, the fins are openings formed into the glass core that do not pass entirely through the glass core. As such, the height of the fin can be less than the thickness of the glass core.

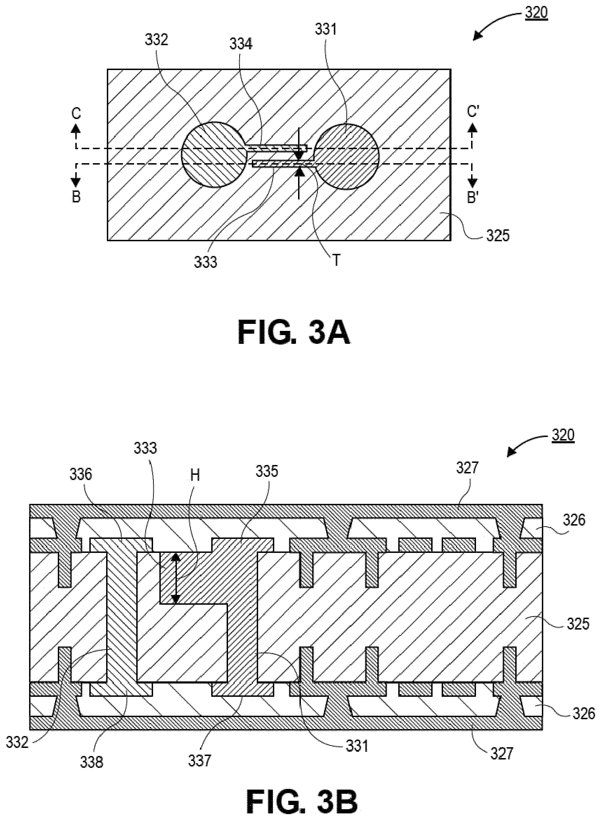

Referring now to Figure 3A, a plan view illustration of a portion of a package substrate 320 is shown, in accordance with an embodiment. In an embodiment, the package substrate 320 comprises a glass core 325. The glass core 325 may be between buildup layers (not shown) which are above and below the glass core 325. In an embodiment, a thickness of the glass core 325 may be between approximately 50μm and approximately 1,000μm. Though, it is to be appreciated that thinner or thicker glass cores may be used in some embodiments.

In an embodiment, the plan view of Figure 3A is through a thickness of the glass core 325. As shown, a pair of vias 331 and 332 may be provided through the glass core 325. The vias 331 and the via 332 may extend entirely through a thickness of the glass core 325. In the illustrated embodiment, the via 331 and the via 332 are shown with different shadings in order to differentiate the two components. However, it is to be appreciated that the via 331 and the via 332 may comprise the same material (e.g., copper or the like). In an embodiment, each via 331 and 332 may comprise a fin 333 and 334, respectively. The fin 333 extends out from the via 331, and the fin 334 extends out from the via 332. The two fins 333 and 334 may each have a thickness T. The thickness T may be smaller than a diameter of the vias 331 and 332. In an embodiment, the face of the fin 333 at least partially overlaps the face of the fin 334. The amount of overlap between the faces and the distance between the fins 333 and 334 determines the amount of mutual capacitance that is provided.

Referring now to Figure 3B, a cross-sectional illustration of the electronic package 320 is shown, in accordance with an embodiment. The illustrated cross-section in Figure 3B includes the cross-section of Figure 3A along line B-B'. In an embodiment, the core 325 may include buildup layers 326 above and below the glass core 325. Conductive routing 327 (e.g., pads, traces, planes, vias, etc.) may be included in the buildup layers 326.

As shown, the via 331 and the via 332 pass entirely through a thickness of the glass core 325. In an embodiment, a pad 335 may be over the via 331, and a pad 337 may be under the via 331. Similarly, a pad 336 may be over the via 332, and a pad 338 may be under the via 332. In the cross-sectional illustration of Figure 3B, only the fin 333 of the via 331 is illustrated. The fin 334 for the other via 332 is out of the plane of Figure 3B. In an embodiment, the fin 333 may have a height H. The height H may be less than a total thickness of the glass core 325. That is, the fin 333 may be a blind feature that does not pass entirely through a thickness of the glass core 325. In an embodiment, the top surface of the fin may be substantially coplanar with a top surface of the glass core 325 and a top surface of the via 331. As used herein, substantially coplanar may refer to two surfaces that are within 2μm of being perfectly coplanar. Since the fin 333 is provided at the top of the glass core 325, the top surface of the fin 333 may contact a portion of the pad 335.

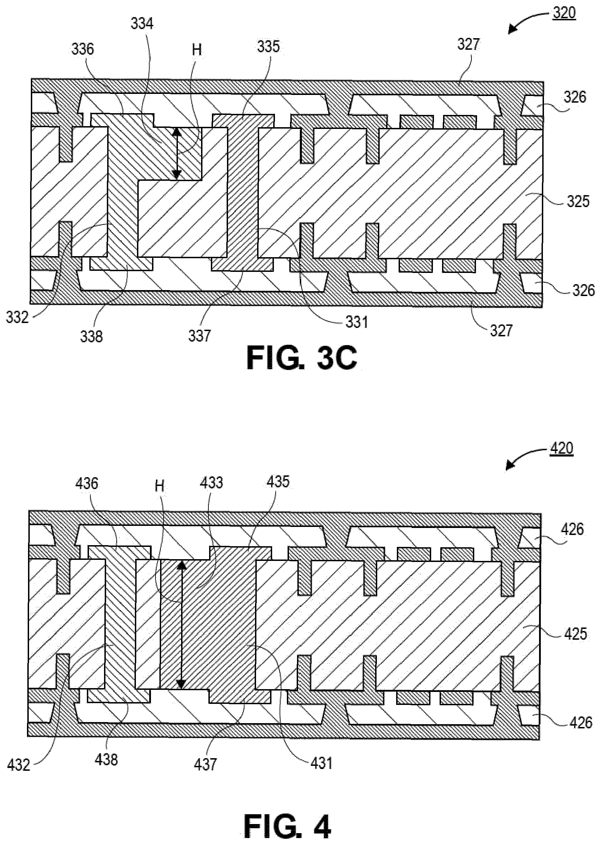

Referring now to Figure 3C, a cross-sectional illustration of the electronic package 320 is shown, in accordance with an embodiment. The illustrated cross-section in Figure 3C includes the cross-section of Figure 3A along line C-C'. In an embodiment, the glass core 325 may include buildup layers 326 above and below the glass core 325. Conductive routing 327 (e.g., pads, traces, planes, vias, etc.) may be included in the buildup layers 326.

In the cross-sectional illustration of Figure 3C, only the fin 334 of the via 332 is illustrated. The fin 333 for the other via 331 is out of the plane of Figure 3C. In an embodiment, the fin 334 may have a height H. The height H may be less than a total thickness of the glass core 325. That is, the fin 334 may be a blind feature that does not pass entirely through a thickness of the glass core 325. In an embodiment, the top surface of the fin 334 may be substantially coplanar with a top surface of the glass core 325 and a top surface of the via 332. In an embodiment, the height H of the fin 334 may be substantially similar to the height H of the fin 333 described above. However, in other embodiments, the height H of the fin 334 may be different than the height H of the fin 333.

Referring now to Figure 4, a cross-sectional illustration of an electronic package 420 is shown, in accordance with an additional embodiment. In an embodiment, the electronic package 420 comprises a glass core 425. Buildup layers 426 may be provided above and below the glass core 425. In an embodiment, a first via 431 and a second via 432 may pass through a thickness of the glass core 425. In an embodiment, the first via 431 may comprise a pad 435 over the top surface and a pad 437 under the bottom surface. Similarly, a pad 436 may be over a top surface of the second via 432 and a pad 438 may be under the bottom surface of the second via 432.

In an embodiment, a fin 433 may extend out from a side of the first via 431. As shown, the first via 431 may have a height H that is substantially equal to a thickness of the glass core 425. As such, the fin 433 may have a top surface that is substantially coplanar with a top surface of the first via 431 and a bottom surface that is substantially coplanar with a bottom surface of the first via 431. In an embodiment, a second fin may extend out from the second via 432. However, the second fin is out of the plane illustrated in Figure 4. It is to be appreciated that faces of the fin 433 and the second fin may overlap in order to provide mutual capacitance. In an embodiment, the second fin may also have a height H that is substantially equal to a thickness of the glass core 425.

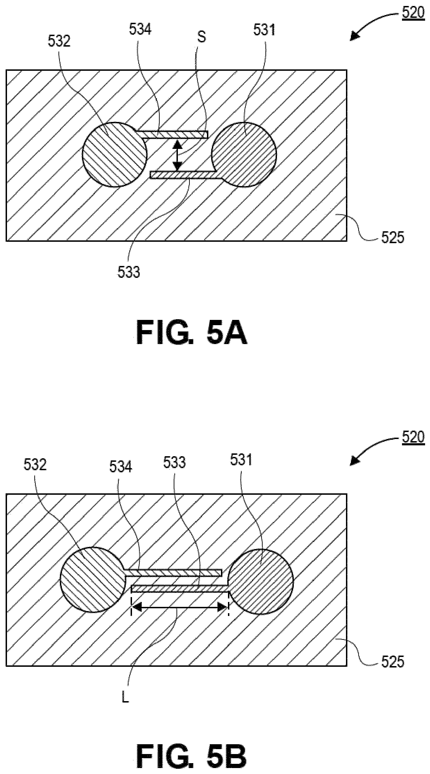

Referring now to Figures 5A-5D, a series of plan view illustrations of electronic packages 520 are shown, in accordance with various embodiments. The embodiments shown in Figures 5A-5D depict some of the degrees of flexibility that are available in order to vary the mutual capacitance provided between two signals.

Referring now to Figure 5A, a plan view illustration of an electronic package 520 is shown, in accordance with an embodiment. In an embodiment, the electronic package 520 comprises a core 525, such as a glass core. In an embodiment, a first via 531 and a second via 532 are provided through a thickness of the core 525. In an embodiment, a first fin 533 extends out from the first via 531, and a second fin 534 extends out from the second via 532. As shown, a spacing S between the two fins 533 and 534 is larger than the spacing illustrated in Figure 3A. Increasing the spacing S may result in a relative decrease in the mutual capacitance. In an embodiment, the spacing S is increased without moving the positioning of the first via 531 and the second via 532. Instead, the positioning of the fins 533 and 534 are shifted towards outer edges of the vias 531 and 532. For example, the fin 533 is shifted down towards a bottom edge of the first via 531, and the fin 534 is shifted up towards a top edge of the second via 532.

Referring now to Figure 5B, a plan view illustration of an electronic package 520 is shown, in accordance with an embodiment. In an embodiment, the electronic package 520 comprises a core 525, such as a glass core. In an embodiment, a first via 531 and a second via 532 are provided through a thickness of the core 525. In the illustrated embodiment, the first via 531 is spaced further away from the second via 532 compared to previous embodiments. Increasing the pitch between the first via 531 and the second via 532 provides room for larger fins 533 and 534. For example, a length L of the fins 533 and 534 may be increased compared to previous embodiments. Increasing the length L provides more surface area overlap between the first fin 533 and the second fin 534. As such, the mutual capacitance can be increased. In an embodiment, the length L may be greater than a diameter of the vias 531 and 532.

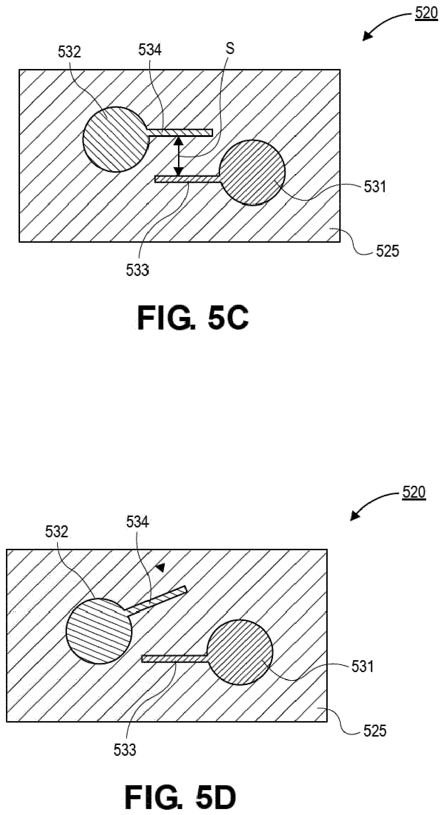

Referring now to Figure 5C, a plan view illustration of an electronic package 520 is shown, in accordance with an embodiment. In an embodiment, the electronic package 520 comprises a core 525, such as a glass core. In an embodiment, a first via 531 and a second via 532 are provided through a thickness of the core 525. As shown in Figure 5C, a spacing S between the first fin 533 and the second fin 534 is increased compared to the spacing between the fins in Figure 3A. However, instead of moving the position of the fins relative to the via (as is the case in Figure 5A), the vias 531 and 532 are offset from each other. That is, the fins 533 and 534 may be close to the middle of the vias 531 and 532, while still providing an increase in the spacing S. In an embodiment, a centerline of the first via 531 is offset from a centerline of the second via 532.

Referring now to Figure 5D, a plan view illustration of an electronic package 520 is shown, in accordance with an additional embodiment. In an embodiment, the electronic package 520 comprises a core 525, such as a glass core. In an embodiment, a first via 531 and a second via 532 are provided through a thickness of the core 525. As shown in Figure 5D, rotation of second via 532 results in a change in the overlap between first fin 533 and the second fin 534. As such the mutual capacitance can be modulated.

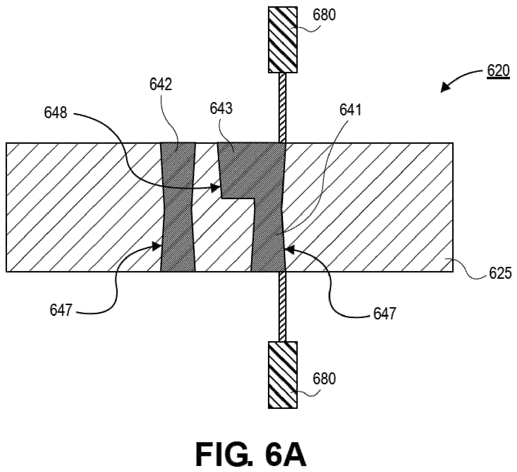

Referring now to Figures 6A-6D, a series of cross-sectional illustrations depicting a process for fabricating vias with overlapping fins is shown, in accordance with an embodiment. In the illustrated embodiment, a laser assisted etching process is used. The laser assisted etching process allows for the formation of via openings through a thickness of the core and blind features in order to form fins extending out from the vias.

Referring now to Figure 6A, a cross-sectional illustration of an electronic package 620 is shown, in accordance with an embodiment. In an embodiment, the electronic package 620 comprises a core 625, such as a glass core. Embodiments include passing a laser 680 over the surface of the core 625. In the illustrated embodiment, a laser 680 is shown over the top surface of the core 625 and the bottom surface of the core 625. However, in other embodiments, the laser exposure may be made from only a single surface of the core 625.

In an embodiment, the laser exposure results in a morphological change in the core 625 to form exposed regions 641, 642, and 643. The morphological change may be the conversion of an amorphous structure to a crystalline structure. The different morphologies have different etch resistances. As such, the exposed regions 641, 642, and 643 may be selectively removed. The exposed regions 641 and 642 are where vias are desired to be located. The exposed regions 641 and 642 may pass entirely through a thickness of the core 625. In an embodiment, the exposed region 643 may be where a fin is desired. In an embodiment, the exposed region 643 is a blind feature that does not pass entirely through a thickness of the core 625. Though not shown in the cross-section of Figure 6A, it is to be appreciated that an exposed region similar to exposed region 643 may be provided extending out from the exposed region 642 in order to have a structure with a pair of overlapping fins.

In an embodiment, the laser exposure may result in sidewalls that are non-vertical. For example, the exposed region 643 may have a tapered sidewall 648. Similarly, the sidewalls 647 of the exposed regions 641 and 642 may be tapered. The sidewalls 647 may have a double taper. That is at the top end, the taper may be inward, and the taper may taper outward starting midway down the exposed regions 641 and 642. Such a double taper may sometimes be referred to as having an hourglass shaped cross-section.

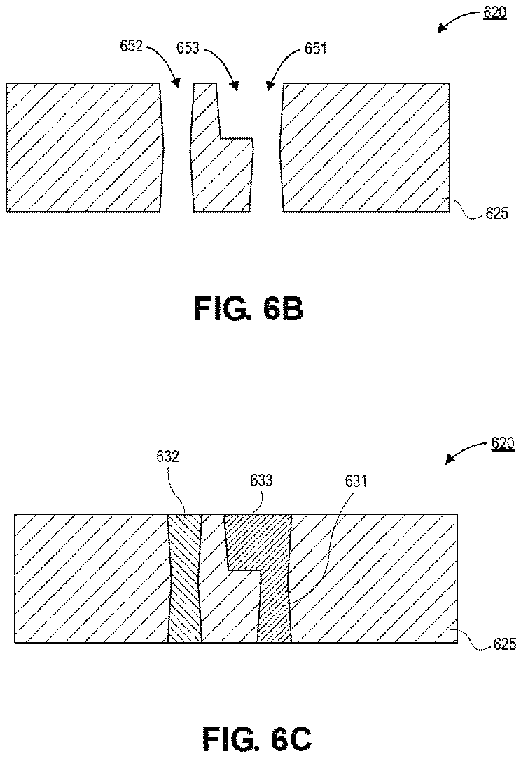

Referring now to Figure 6B, a cross-sectional illustration of the electronic package 620 after an etching process is shown, in accordance with an embodiment. In an embodiment, the etching process may be a wet etching process. The etching process selectively removes the exposed regions 641, 642, and 643. As such, a first via opening 651 may extend through a thickness of the core 625 and a second via opening 652 may extend through a thickness of the core 625. Additionally, a blind opening 653 may extend partially through a thickness of the core 625. The blind opening 653 may intersect the first via opening 651.

Referring now to Figure 6C, a cross-sectional illustration of the electronic package 620 after a plating process is shown, in accordance with an embodiment. In an embodiment, the plating process results in the formation of a first via 631 and a second via 632. Additionally, a fin 633 extends out from a sidewall of the first via 631. In the illustrated embodiment, the first via 631 and the fin 633 are shown with a different shading than the second via 632. However, it is to be appreciated that the first via 631, the fin 633, and the second via 632 may be formed with a single plating process. As such, the material of all three feature may be the same (e.g., copper).

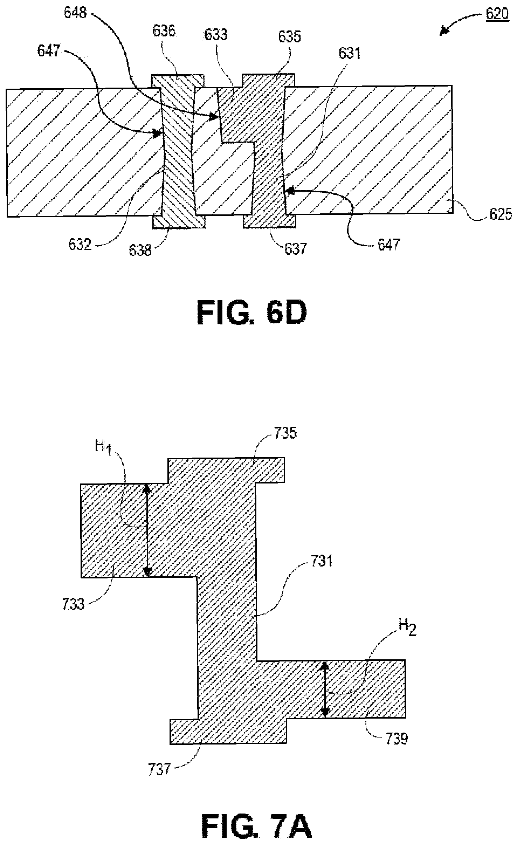

Referring now to Figure 6D, a cross-sectional illustration of the electronic package 620 after pads are formed over the vias is shown, in accordance with an embodiment. In an embodiment, a top pad 635 may be provided over a top surface of the first via 631, and a bottom pad 637 may be provided under a bottom surface of the first via 631. Similarly, a top pad 636 may be provided over a top surface of the second via 632, and a bottom pad 638 may be provided under a bottom surface of the second via 632. In an embodiment, the fin 633 may contact a portion of the top pad 635. As shown, the first via 631 and the second via 632 may have tapered sidewalls 647 (e.g., hourglass shaped profiles). Additionally, the fin 633 may have a tapered sidewall 648. In an embodiment, a bottom of the fin 633 may be above the junction between the oppositely tapered portions of the tapered sidewall 648.

Referring now to Figure 7A, a cross-sectional illustration of a via 731 is shown, in accordance with an additional embodiment. Instead of having a single fin, the embodiment shown in Figure 7A includes a pair of fins 733 and 739. The use of two fins 733 and 739 allows for a single via 731 to be capacitively coupled to multiple different vias. For example, when two fins 733 and 739 are provided, the via 731 may be coupled to a second via and a third via.

In an embodiment, a first fin 733 may be at a top of the via 731, and a second fin 739 may be at a bottom of the via 731. The first fin 733 may contact a portion of the top pad 735, and the second fin 739 may contact a portion of the bottom pad 737. In an embodiment, the first fin 733 may have a first height $H_1$, and the second fin 739 may have a second height $H_2$. The first height $H_1$ and the second height $H_2$ may be substantially equal to each other. In other embodiments, as shown in Figure 7A, the first height $H_1$ may be different than the second height $H_2$. Similarly, lengths of the first fin 733 and the second fin 739 may be similar or different.

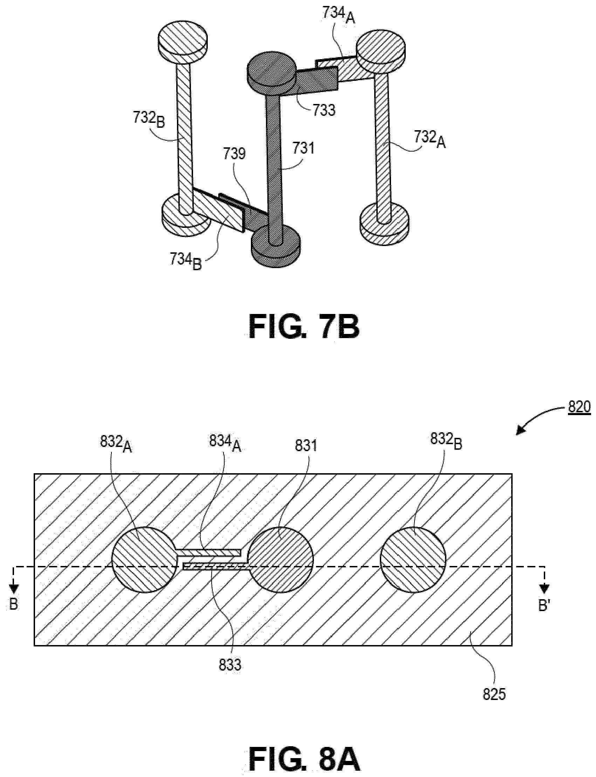

Referring now to Figure 7B, a perspective view illustration of a plurality of capacitively coupled vias is shown, in accordance with an embodiment. In an embodiment, a first via 731 may be capacitively coupled to a second via $732_A$ and a third via $732_B$. For example, the first via 731 may include a first fin 733 and a second fin 739. The first fin 733 may be at a top of the first via 731, and be capacitively coupled to a fin $734_A$ that extends out from the second via $732_A$. Additionally, the second fin 739 may be at a bottom of the first via 731, and may be capacitively coupled to a fin $734_B$ that extends out from the third via $732_B$.

Referring now to Figure 8A, a plan view illustration of a portion of an electronic package 820 is shown, in accordance with an embodiment. In an embodiment, the electronic package 820 comprises a core 825, such as a glass core 825. In an embodiment, a first via 831, a second via $832_A$, and a third via $832_B$ are provided through a thickness of the core 825. In an embodiment, a first fin 833 may extend out from the first via 831, and a second fin $834_A$ may extend out from the second via $832_A$. The first via 831 may also be capacitively coupled to the third via $832_B$ through fins that are not visible in Figure 8A since they are at the bottom of the vias 831 and $832_B$.

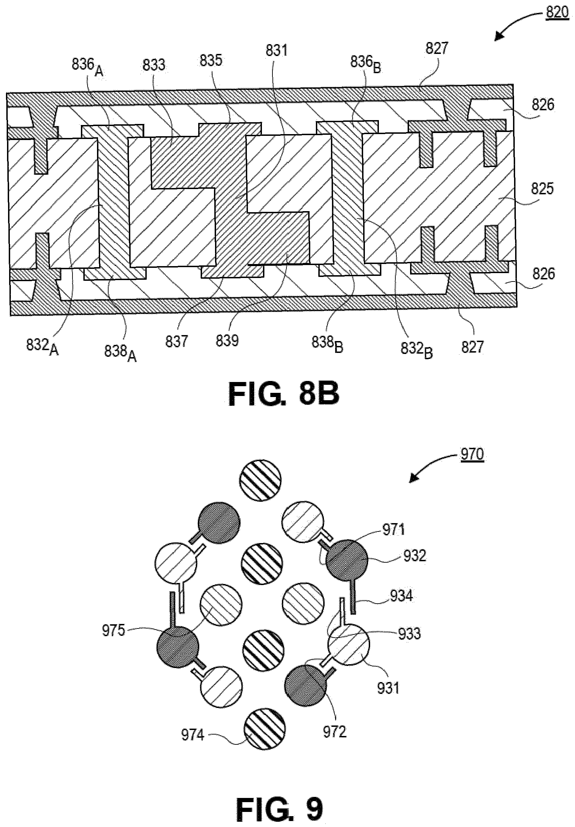

Referring now to Figure 8B, a cross-sectional illustration of the electronic package 820 is shown, in accordance with an embodiment. In an embodiment, buildup layers 826 may be provided above and below the core 825. Conductive features 827 (e.g., traces, pads, vias, planes, etc.) may be provided in the buildup layers 826. As shown, the first via 831 comprises a top pad 835 and a bottom pad 837. Similarly, top pads $836_A$ and $836_B$ may be over the second via $832_A$ and the third via $832_B$. Additionally, bottom pads $838_A$ and $838_B$ may be under the second via $832_A$ and the third via $832_B$.

As shown, a first fin 833 extends out from the first via 831 towards the second via $832_A$. The first fin 833 may be at a top surface of the first via 831. The first fin 833 may overlap a portion of a fin (not shown) that extends away from the second via $832_A$. Additionally, a second fin 839 extends out from the first via 831 towards the third via $832_B$. The second fin 839 may be at a bottom surface of the first via 831. The second fin 839 may overlap a portion of a fin (not shown) that extends away from the third via $832_B$. While the fins 833 and 839 are shown as being at a top of the first via 831 and at a bottom of the first via 831, it is to be appreciated that the fins 833 and 839 may both be provided on the same end of the first via 831. For example, the fins 833 and 839 may both be at the top of the first via 831, but extend out in different directions from each other.

Referring now to Figure 9, a plan view illustration of an array of signals 970 is shown, in accordance with an embodiment. In a particular embodiment, the array of signals 970 may be considered DDR byte. The signals 970 may be single ended signals that suffer from far-end crosstalk that are inductive in nature. While a particular arrangement is shown, it is to be appreciated that other arrangements of signaling vias and the like may be used in accordance with various embodiments. In an embodiment, signaling vias 931 or 932 may include fins that extend out to capacitively couple with a neighboring signaling via 931 or 932. For example, the labeled first via 931 includes a first fin 933 and a second fin 972. The labeled second via 932 comprises a fin 934 that faces fin 933 and a fin 971. Also shown in Figure 9 are strobe vias 974 and ground (Vss) vias 975.

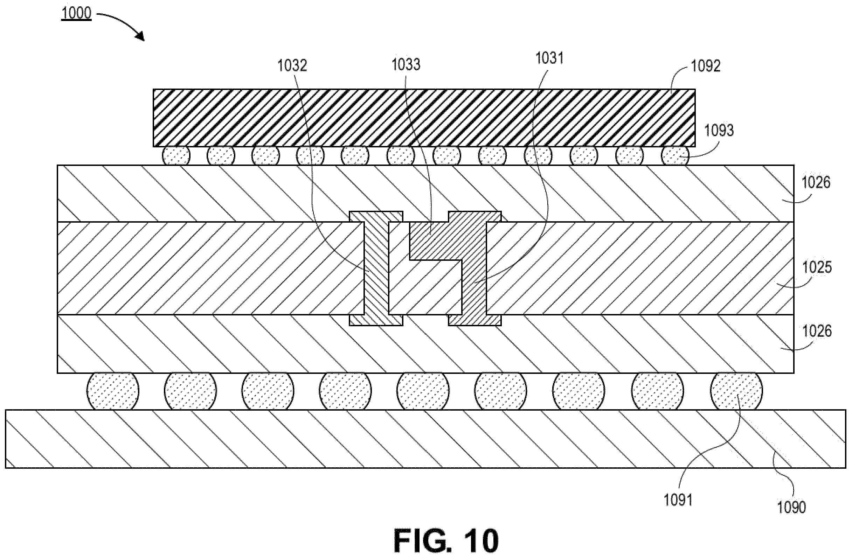

Referring now to Figure 10, a cross-sectional illustration of an electronic system 1000 is shown, in accordance with an embodiment. In an embodiment, the electronic system 1000 comprises a board 1090, such as a printed circuit board (PCB) or the like. In an embodiment, the board 1090 is coupled to a package substrate comprising a core 1025 and buildup layers 1026. In an embodiment, the board 1090 is coupled to the bottom buildup layers 1026 by interconnects 1091. While shown as solder balls, it is to be appreciated that any interconnect architecture may be used, in accordance with various embodiments. In an embodiment, capacitively coupled vias 1031 and 1032 may be provided a core 1025, such as a glass core 1025. In an embodiment a fin 1033 may extend out from the via 1031. A similar fin (out of the plane of Figure 10) may extend out from the via 1032. The two fins overlap each other in order to provide mutual capacitance in order to minimize FEXT. In an embodiment, a die 1092 may be coupled to the top buildup layers 1026 by interconnects 1093. The interconnects 1093 may be any first level interconnect (FLI) architecture. In an embodiment, the die 1092 may be a processor, a memory, a graphics process, or any other computational die.

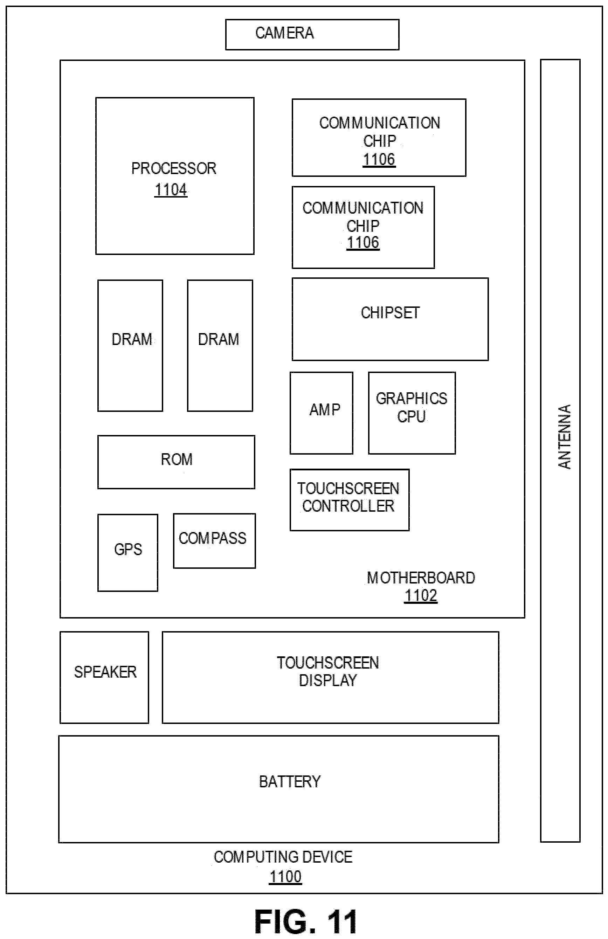

Figure 11 illustrates a computing device 1100 in accordance with one implementation of the invention. The computing device 1100 houses a board 1102. The board 1102 may include a number of components, including but not limited to a processor 1104 and at least one communication chip 1106. The processor 1104 is physically and electrically coupled to the board 1102. In some implementations the at least one communication chip 1106 is also physically and electrically coupled to the board 1102. In further implementations, the communication chip 1106 is part of the processor 1104.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 1106 enables wireless communications for the transfer of data to and from the computing device 1100. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1106 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 1100 may include a plurality of communication chips 1106. For instance, a first communication chip 1106 may be dedicated to shorter range wireless communications such as Wi-Fi and Bluetooth and a second communication chip 1106 may be dedicated to longer range wireless communications such as GPS, EDGE, GPRS, CDMA, WiMAX, LTE, Ev-DO, and others.

The processor 1104 of the computing device 1100 includes an integrated circuit die packaged within the processor 1104. In some implementations of the invention, the integrated circuit die of the processor may be part of an electronic package that comprises a glass core with vias that are capacitively coupled by overlapping fins that extend out from the vias, in accordance with embodiments described herein. The term "processor" may refer to any device or portion of a device that processes electronic data from registers and/or memory to transform that electronic data into other electronic data that may be stored in registers and/or memory.

The communication chip 1106 also includes an integrated circuit die packaged within the communication chip 1106. In accordance with another implementation of the invention, the integrated circuit die of the communication chip may be part of an electronic package that comprises a glass core with vias that are capacitively coupled by overlapping fins that extend out from the vias, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: an electronic package, comprising: a core, wherein the core comprises glass; a first via through the core; a first fin that extends out laterally from the first via; a second via through the core; and a second fin that extends out laterally from the second via, wherein a face of the first fin overlaps a face of the second fin.

Example 2: the electronic package of Example 1, wherein the first fin has a height that is smaller than a height of the first via.

Example 3: the electronic package of Example 2, wherein the first fin has a top surface substantially coplanar with a top surface of the first via, and a bottom surface that is above a bottom surface of the first via.

Example 4: the electronic package of Example 2, wherein the second fin has the height.

Example 5: the electronic package of Example 4, wherein a top surface of the first fin is substantially coplanar with a top surface of the second fin.

Example 6: the electronic package of Example 2, wherein the second fin has a height that is different than the height of the first fin.

Example 7: the electronic package of Examples 1-6, further comprising: a third fin extending out laterally from the first via, wherein the third fin extends out a different direction than the first fin.

Example 8: the electronic package of Example 7, wherein the first fin is at a top of the first via, and wherein the third fin is at a bottom of the first via.

Example 9: the electronic package of Example 8, further comprising: a third via through the core; and a fourth fin extending out laterally from the third via, wherein a surface of the fourth fin overlaps a surface of the third fin.

Example 10: the electronic package of Examples 1-9, wherein the first via and the second via are part of single ended signaling interfaces.

Example 11: an electronic package, comprising: a substrate with a first surface and a second surface opposite from the first surface, wherein the substrate comprises glass; a via through the substrate from the first surface to the second surface; and a fin extending out from the via.

Example 12: the electronic package of Example 11, wherein a thickness of the fin is less than a diameter of the via.

Example 13: the electronic package of Example 11 or Example 12, wherein a length of the fin is greater than a diameter of the via.

Example 14: the electronic package of Examples 11-13, wherein a top surface of the fin is substantially coplanar with the first surface of the substrate.

Example 15: the electronic package of Examples 11-14, wherein a height of the fin is less than a height of the via.

Example 16: the electronic package of Examples 11-15, wherein a height of the fin is substantially equal to a height of the via.

Example 17: the electronic package of Examples 11-16, wherein the via is part of a single ended signaling interface.

Example 18: the electronic package of Examples 11-17, further comprising: a first pad over the via on the first surface of the substrate; and a second pad under the via on the second surface of the substrate.

Example 19: the electronic package of Examples 11-18, wherein a sidewall of the fin is tapered.

Example 20: electronic package of Example 19, wherein a sidewall of the via comprises a first taper and a second taper, wherein a direction of the first taper is opposite from a direction of the second taper.

Example 21: the electronic package of Example 20, wherein a bottom of the fin is above a junction between the first taper and the second taper.

Example 22: the electronic package of Examples 11-21, further comprising: a second fin extending out from the via.

Example 23: the electronic package of Example 22, wherein the fin is at a top of the via, and wherein the second fin is at a bottom of the via.

Example 24: an electronic system, comprising: a board; a package substrate coupled to the board, wherein a single ended signaling interface is provided in the package substrate, wherein the single ended signaling interface comprises: a first via through a package core; a first fin extending out from the first via; a second via through the package core; a second fin extending out from the second via, wherein a surface of the second fin overlaps a surface of the first fin; and a die coupled to the package substrate.

Example 25: the electronic system of Example 24, wherein the first fin is at a top of the first via, and wherein the second fin is at a top of the second via.

**Claims**

1. An electronic package, comprising:

   a core, wherein the core comprises glass;
   a first via through the core;
   a first fin that extends out laterally from the first via;
   a second via through the core; and
   a second fin that extends out laterally from the second via, wherein a face of the first fin overlaps a face of the second fin.

2. The electronic package of claim 1, wherein the first fin has a height that is smaller than a height of the first via.

3. The electronic package of claim 2, wherein the first fin has a top surface substantially coplanar with a top surface of the first via, and a bottom surface that is above a bottom surface of the first via.

4. The electronic package of claim 2 or 3, wherein the second fin has the height.

5. The electronic package of claim 4, wherein a top surface of the first fin is substantially coplanar with a top surface of the second fin.

6. The electronic package of claim 2, 3, 4 or 5, wherein the second fin has a height that is different than the height of the first fin.

7. The electronic package of claim 1, 2, 3, 4, 5 or 6, further comprising:
a third fin extending out laterally from the first via, wherein the third fin extends out a different direction than the first fin.

8. The electronic package of claim 7, wherein the first fin is at a top of the first via, and wherein the third fin is at a bottom of the first via.

9. The electronic package of claim 8, further comprising:

a third via through the core; and
a fourth fin extending out laterally from the third via, wherein a surface of the fourth fin overlaps a surface of the third fin.

10. The electronic package of claim 1, 2, 3, 4, 5, 6, 7, 8 or 9, wherein the first via and the second via are part of single ended signaling interfaces.

11. A method of fabricating an electronic package, the method comprising:

providing a core, wherein the core comprises glass;
forming a first via through the core;
forming a first fin that extends out laterally from the first via;
forming a second via through the core; and
forming a second fin that extends out laterally from the second via, wherein a face of the first fin overlaps a face of the second fin.

12. The method of claim 11, wherein the first fin has a height that is smaller than a height of the first via.

13. The method of claim 12, wherein the first fin has a top surface substantially coplanar with a top surface of the first via, and a bottom surface that is above a bottom surface of the first via.

14. The method of claim 12 or 13, wherein the second fin has the height.

15. The method of claim 14, wherein a top surface of the first fin is substantially coplanar with a top surface of the second fin.

FEXT on Victim

**FIG. 1**

**FIG. 2**

**FIG. 3A**

**FIG. 3B**

FIG. 3C

FIG. 4

FIG. 5A

FIG. 5B

**FIG. 5C**

**FIG. 5D**

FIG. 6A

620

652     653                    651

625

**FIG. 6B**

620

632        633      631

625

**FIG. 6C**

FIG. 6D

FIG. 7A

**FIG. 7B**

**FIG. 8A**

**FIG. 8B**

**FIG. 9**

**FIG. 10**

EP 4 199 070 A1

CAMERA

PROCESSOR
1104

COMMUNICATION
CHIP
1106

COMMUNICATION
CHIP
1106

DRAM

DRAM

CHIPSET

AMP

GRAPHICS
CPU

ROM

TOUCHSCREEN
CONTROLLER

GPS

COMPASS

ANTENNA

MOTHERBOARD
1102

SPEAKER

TOUCHSCREEN
DISPLAY

BATTERY

COMPUTING DEVICE
1100

# FIG. 11

Europäisches
Patentamt

European
Patent Office

Office européen
des brevets

**EUROPEAN SEARCH REPORT**

Application Number

EP 22 21 3185

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 045 877 A1 (IBM [US]) 17 February 1982 (1982-02-17) * page 1, line 1 - line 19 * * page 4, line 5 - line 30 * * page 6, line 23 - page 7, line 21 * * figures 1,4 * * page 11, line 13 * | 1-15 | INV. H01L23/15 H01L23/498 H01L23/64 |
| X | US 2014/268614 A1 (ZHANG ZHICHAO [US] ET AL) 18 September 2014 (2014-09-18) * paragraph [0001] - paragraph [0004] * * paragraph [0017] - paragraph [0024] * * paragraph [0029] * * figures 1A-1C, 3A * | 1-15 | |
| A | WO 2020/227033 A1 (RAMBUS INC [US]) 12 November 2020 (2020-11-12) * paragraphs [0001], [0013], [0014], [0017] * * paragraph [0021] - paragraph [0027] * * figure 2 * | 1-15 | |
| A | EP 3 554 200 A1 (TOPPAN PRINTING CO LTD [JP]) 16 October 2019 (2019-10-16) * paragraph [0001] - paragraph [0011] * * paragraph [0020] - paragraph [0069] * * paragraph [0087] - paragraph [0103] * * figures 1,2,4,9 * | 1-15 | TECHNICAL FIELDS SEARCHED (IPC) H01L |

The present search report has been drawn up for all claims

| Place of search | Date of completion of the search | Examiner |
|---|---|---|
| The Hague | 25 April 2023 | Keller, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.......................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 21 3185

This annex lists the patent family members relating to the patent documents cited in the above-mentioned European search report.
The members are as contained in the European Patent Office EDP file on
The European Patent Office is in no way liable for these particulars which are merely given for the purpose of information.

25-04-2023

| Patent document cited in search report | | Publication date | Patent family member(s) | | Publication date |
|---|---|---|---|---|---|
| EP 0045877 | A1 | 17-02-1982 | EP | 0045877 A1 | 17-02-1982 |
| | | | JP | S5737818 A | 02-03-1982 |
| | | | JP | S6348172 B2 | 28-09-1988 |
| | | | US | 4349862 A | 14-09-1982 |
| US 2014268614 | A1 | 18-09-2014 | CN | 104051425 A | 17-09-2014 |
| | | | US | 2014268614 A1 | 18-09-2014 |
| WO 2020227033 | A1 | 12-11-2020 | US | 2022319980 A1 | 06-10-2022 |
| | | | WO | 2020227033 A1 | 12-11-2020 |
| EP 3554200 | A1 | 16-10-2019 | CN | 110036699 A | 19-07-2019 |
| | | | EP | 3554200 A1 | 16-10-2019 |
| | | | JP | 6816486 B2 | 20-01-2021 |
| | | | JP | 2018093141 A | 14-06-2018 |
| | | | KR | 20190093612 A | 09-08-2019 |
| | | | TW | 201828792 A | 01-08-2018 |
| | | | US | 2019287930 A1 | 19-09-2019 |
| | | | WO | 2018105618 A1 | 14-06-2018 |

EPO FORM P0459

For more details about this annex : see Official Journal of the European Patent Office, No. 12/82